# EUROPEAN PATENT APPLICATION

(11) **EP 1 601 004 A2**
(43) Date of publication of application: **30.11.2005**
(21) Application number: 05006429.4
(22) Date of filing: 23.03.2005
(51) Int. Cl.: H01L 21/00

(54) **Electronic device manufacturing apparatus**

(30) Priority: 27.05.2004 JP 2004157139
(71) Applicant: MATSUSHITA ELECTRIC INDUSTRIAL CO., LTD., Kadoma-shi, Osaka 571-8501 (JP)
(72) Inventor: Niwayama, Masahiko, Shimogyo-ku Kyoto-shi Kyoto 600-8015 (JP); Yoneda, Kenji, Kyoto-shi Kyoto 601-8212 (JP); Takahashi, Kazuma, Kyoto-shi Kyoto 601-8047 (JP)
(74) Representative: Grünecker, Kinkeldey, Stockmair & Schwanhäusser Anwaltssozietät

(57) **Abstract**

An electronic device manufacturing apparatus is provided with a support which includes a shelf for supporting a substrate, a sensor which obtains the position of the substrate and a position correcting mechanism which corrects the position of the substrate. Or alternatively, an electronic device manufacturing apparatus is provided with a support which includes a shelf for supporting a substrate and the shelf includes a substrate support plane which forms an angle of 22° or more to 90° or less with a horizontal plane.

## Description

### CROSS-REFERENCE TO RELATED APPLICATION

This non-provisional application claims priority under 35 U.S.C. § 119(a) on Patent Application No. 2004-157139 filed in Japan on May 27, 2004, the entire contents of which are hereby incorporated by reference.

### BACKGROUND OF THE INVENTION

### (a) Field of the Invention

The present invention relates to an electronic device manufacturing apparatus. In particular, it relates to a semiconductor manufacturing apparatus which performs rapid thermal processing.

### (b) Description of Related Art

In semiconductor manufacturing processes, highly accurate temperature control is often required during substrate processing. In particular, in rapid thermal processing (hereinafter abbreviated as RTP) which determines device characteristics, it is necessary to ensure temperature reproducibility and enhance temperature uniformity across the surface of a wafer.

For example, as described in Japanese Unexamined Patent Publication No. 2002-503884, importance has been placed on how to improve the temperature uniformity across the wafer surface in an apparatus which performs RTP.

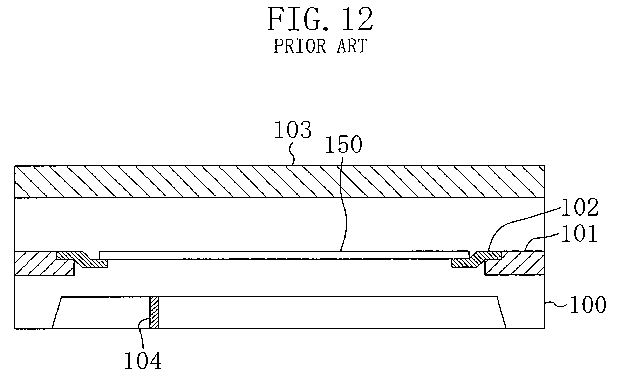

FIG. **12** is a view illustrating a schematic configuration of a conventional RTP apparatus. In an RTP apparatus having no susceptor, in general, an edge ring is used in a process chamber to support a substrate by the periphery thereof. More specifically, as shown in FIG. **12,** a semiconductor substrate **150** is placed on an edge ring **101** which is a substrate support arranged on the sidewall of a chamber **100.** The edge ring **101** includes a shelf **102** for supporting the semiconductor substrate **150.** The semiconductor substrate **150** is heated from above by a heater **103** provided at the upper part of the chamber **100.** The heater **103** is divided into two or more regions so that the heating intensity of the heater **103** can be adjusted region by region. The temperature of the semiconductor substrate **150** (to be exact, the temperature of the rear surface of the substrate) is measured by a pyrometer **104** arranged at the bottom of the chamber **100.** Though not shown, the edge ring **101** is generally provided with a rotating mechanism, and therefore it rotates together with the semiconductor substrate **150** during substrate processing.

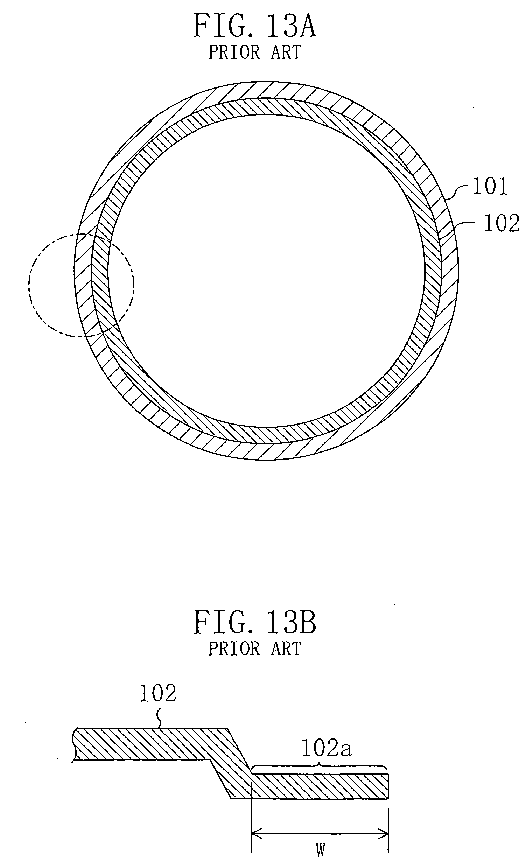

FIG. **13A** shows a planar configuration of the edge ring **101** including the shelf **102,** while FIG. **13B** shows a cross-sectional configuration of the shelf **102** viewed at any part of the edge ring **101** shown in FIG. **13A** (e.g., a region circled with an alternate long and short dash line in FIG. **13A).** The shelf **102** shown in FIG. **13B** includes a horizontal substrate support plane **102a** having a length **W** (length in the direction of the wafer diameter) of about 5 mm in general. The diameter (outer diameter) of a ring-shaped part, which serves as the substrate support plane **102a** (inner diameter of the shelf **102),** is 1 to 10 mm larger than the diameter of a wafer as the semiconductor substrate **150.**

### SUMMARY OF THE INVENTION

When the edge ring **101** is used to support the semiconductor substrate **150,** heat balance at the periphery of the semiconductor substrate **150** contacting the edge ring **101** varies from that at the other part of the semiconductor substrate **150** not contacting the edge ring **101.** More specifically, in conventional thermal processing performed at about 1,000°C, in which temperature is raised by about 50°C/sec to reach a processing temperature and the processing temperature is maintained for about 10 seconds, temperature uniformity is obtained across the entire surface of the semiconductor substrate **150** by adjusting the intensities of the divided regions of the heater **103.** However, if temperature is raised by 100°C or higher/sec (i.e., the temperature is changed rapidly) to reach a processing temperature much higher than 1,000°C as in spike RTA (rapid thermal annealing) which has been demanded in recent years (processing temperature T [°C] is maintained for substantially 0 second and processing temperature not lower than (T-50) [°C] is maintained for 2 seconds or less), it is getting difficult to ensure the temperature uniformity across the wafer surface by merely adjusting the intensities of the divided regions of the heater **103.**

Under the above-described circumstances, an object of the present invention is to provide an electronic device manufacturing apparatus which allows thermal processing while excellent temperature uniformity is ensured across the wafer surface.

To achieve the object, the inventors of the present application have conducted various studies. The results are described below.

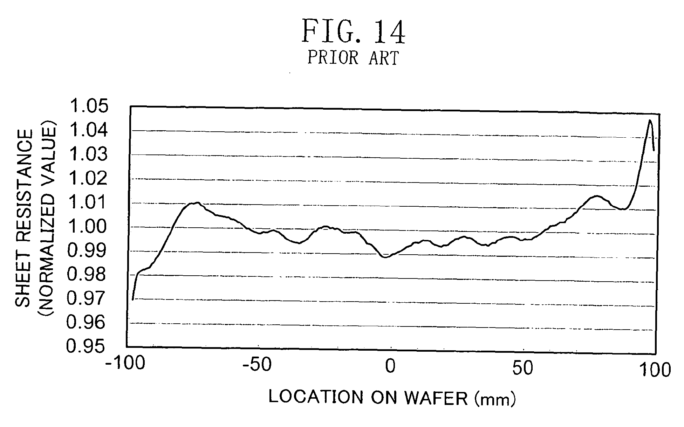

FIG. **14** is a graph of the measurement results of sheet resistance at the surface of the semiconductor substrate **150** which has been implanted with p- or n-type impurities and then subjected to RTP (spike RTA) using a conventional RTP apparatus. In FIG. **14,** the lateral axis indicates locations on the wafer as the semiconductor substrate **150** (represented by the distance from the center point of the wafer (0) along the direction of the wafer diameter) and the longitudinal axis indicates normalized sheet resistance.

As shown in FIG. **14,** through the spike RTA, the semiconductor substrate **150** shows significant variations in sheet resistance at the periphery thereof. This indicates that the temperature on the wafer surface has been greatly varied. Further, in spite that the semiconductor substrate **150** is rotated, the maximum and minimum sheet resistances co-exist on both ends of the wafer in the direction of the wafer diameter. Thus, the temperature uniformity across the wafer surface cannot be fully ensured by merely adjusting the intensities of the divided regions of the heater **103.** This results from a great difference in heat balance among parts of the periphery of the semiconductor substrate **150** due to a difference in area of contact between the parts of the periphery of the semiconductor substrate **150** and the edge ring **101.** More specifically, when the center of the semiconductor substrate **150** is not aligned with the center of the edge ring **101,** the parts of the periphery of the semiconductor substrate **150** vary in area of contact with the edge ring **101.** This brings about temperature nonuniformity across the wafer surface.

Further, heat balance at the periphery of the semiconductor substrate **150** contacting the edge ring **101** is greatly different from that at the other part of the semiconductor substrate **150** not contacting the edge ring **101.** The degree of temperature nonuniformity increases with an increase in area of contact between the periphery of the semiconductor substrate **150** and the edge ring **101.**

As described above, it has been found that the temperature uniformity across the surface of the semiconductor substrate **150** greatly depends on both the positional relationship and the area of contact between the semiconductor substrate **150** and the edge ring **101.**

Based on the above finding, the present invention has been achieved. More specifically, a first electronic device manufacturing apparatus of the present invention comprises a support which includes a shelf for supporting a substrate, a sensor which obtains the position of the substrate and a position correcting mechanism which corrects the position of the substrate.

Further, a method for manufacturing the first electronic device manufacturing apparatus of the present invention comprises the steps of: placing the substrate on the shelf; obtaining the position of the substrate placed on the shelf using the sensor; and correcting the position of the substrate using the position correcting mechanism based on the position of the substrate obtained by the sensor.

According to the first electronic device manufacturing apparatus and the manufacturing method, the sensor obtains the position of the substrate placed on the shelf of the support, and then the position correcting mechanism corrects the position of the substrate based on the obtained results. This allows correcting the position of the substrate such that the center of the substrate is aligned with the center of the shelf. Therefore, every part of the periphery of the substrate contacts the shelf with the same area, i.e., the state of contact of the periphery of the semiconductor substrate with the shelf becomes the same in every part thereof. As a result, heat balance at the periphery of the substrate contacting the shelf is brought into better balance with that at the other part of the substrate not contacting the shelf. Thus, temperature uniformity improves across the substrate surface during thermal processing, specifically RTP.

A second electronic device manufacturing apparatus comprises a support which includes a shelf for supporting a substrate, wherein the shelf includes a substrate support plane which forms an angle of 22° or more to less than 23° with a horizontal plane.

According to the second electronic device manufacturing apparatus, the shelf for supporting the substrate includes the substrate support plane which forms an angle of 22° or more to less than 23° with a horizontal plane. Even if the center of the substrate is misaligned with the center of the shelf when the substrate is placed on the shelf, the substrate slides along the substrate support plane of the shelf under its own weight, whereby the centers of the substrate and the shelf are aligned in the end. Therefore, every part of the periphery of the substrate contacts the shelf with the same area, i.e., the state of contact of the periphery of the semiconductor substrate with the shelf becomes the same in every part thereof. As a result, heat balance at the periphery of the substrate contacting the shelf is brought into better balance with that at the other part of the substrate not contacting the shelf. Thus, temperature uniformity improves across the substrate surface during thermal processing, specifically RTP. Where the centers of the substrate and the shelf are aligned, the substrate support plane is brought into contact with a beveled face of the substrate whose length is as small as about 0.5 mm (length in the direction of the wafer diameter). This reduces the area of contact between the periphery of the substrate and the shelf. As a result, heat balance at the periphery of the substrate contacting the shelf becomes less different from that at the other part of the substrate not contacting the shelf. Thus, temperature uniformity further improves across the substrate surface during RTP.

A third electronic device manufacturing device of the present invention comprises a support which includes a shelf for supporting a substrate, wherein the shelf includes a substrate support plane which forms an angle of 23° or more to less than 90° with a horizontal plane.

According to the third electronic device manufacturing device of the present invention, the shelf supporting the substrate includes the substrate support plane which forms an angle of 23° or more to less than 90° with a horizontal plane. Even if the center of the substrate is misaligned with the center of the shelf when the substrate is placed on the shelf, the substrate slides along the substrate support plane of the shelf under its own weight, whereby the centers of the substrate and the shelf are aligned in the end. Therefore, every part of the periphery of the substrate contacts the shelf with the same area, i.e., the state of contact of the periphery of the semiconductor substrate with the shelf becomes the same in every part thereof. As a result, heat balance at the periphery of the substrate contacting the shelf is brought into better balance with that at the other part of the substrate not contacting the shelf. Thus, temperature uniformity improves across the substrate surface during thermal processing, specifically RTP. Where the centers of the substrate and the shelf are aligned, the substrate support plane is brought into contact with an edge of the substrate at which a beveled face of the substrate meets an end face of the substrate. This reduces the area of contact between the periphery of the substrate and the shelf to a great extent. As a result, heat balance at the periphery of the substrate contacting the shelf becomes less different from that at the other part of the substrate not contacting the shelf. Thus, temperature uniformity further improves across the substrate surface during RTP.

A fourth electronic device manufacturing apparatus of the present invention comprises a support which includes a shelf for supporting a substrate, wherein the shelf includes a substrate support plane which forms an angle of 90° with a horizontal plane.

According to the fourth electronic device manufacturing apparatus, the shelf supporting the substrate includes the substrate support plane which forms an angle of 90° with a horizontal plane. That is, the substrate is supported in such a state that an end face thereof contacts the substrate support plane of the shelf, whereby the centers of the substrate and the shelf are aligned. Therefore, every part of the periphery of the substrate contacts the shelf with the same area, i.e., the state of contact of the periphery of the semiconductor substrate with the shelf becomes the same in every part thereof. As a result, heat balance at the periphery of the substrate contacting the shelf is brought into better balance with that at the other part of the substrate not contacting the shelf. Thus, temperature uniformity improves across the substrate surface during thermal processing, specifically RTP. Where the centers of the substrate and the shelf are aligned, the substrate support plane is brought into contact with the end face of the substrate whose length is as small as about 0.5 mm or less. This reduces the area of contact between the periphery of the substrate and the shelf. As a result, heat balance at the periphery of the substrate contacting the shelf becomes less different from that at the other part of the substrate not contacting the shelf. Thus, temperature uniformity further improves across the substrate surface during RTP.

As described above, the present invention relates to an electronic device manufacturing apparatus which performs thermal processing. The present invention is highly useful for its effect of giving excellent temperature uniformity across the wafer surface when applied to RTP.

### BRIEF DESCRIPTION OF THE DRAWINGS

FIG. **1** is a sectional view illustrating a schematic configuration of an electronic device manufacturing apparatus according to Embodiment 1 of the present invention.
FIG. **2** is a view illustrating a feature of the electronic device manufacturing apparatus according to Embodiment 1 of the present invention.
FIG. **3** is a view illustrating a transfer arm as a substrate position correcting mechanism provided outside a process chamber of the electronic device manufacturing apparatus according to Embodiment 1 of the present invention.
FIG. **4A** is a view illustrating a planar configuration of an edge ring including a shelf of the electronic device manufacturing apparatus according to Embodiment 1 of the present invention and FIG. **4B** is a view illustrating a cross-sectional configuration of the shelf viewed at any part of the edge ring shown in FIG. **4A.**
FIG. **5** is a graph of the measurement results of sheet resistance at the surface of a semiconductor substrate which has been implanted with p- or n-type impurities and then subjected to spike RTA using the electronic device manufacturing apparatus of Embodiment 1 of the present invention.
FIG. **6A** is a view illustrating a planar configuration of an edge ring including a shelf of an electronic device manufacturing apparatus according to Embodiment 2 of the present invention and FIG. **6B** is a view illustrating a cross-sectional configuration of the shelf viewed at any part of the edge ring shown in FIG. **6A.**
FIG. **7A** is a view illustrating a cross-sectional configuration of the periphery of a semiconductor substrate to be placed on the shelf of the edge ring of the electronic device manufacturing apparatus according to Embodiment 2 of the present invention and FIG. **7B** is a view illustrating the semiconductor substrate placed on the shelf of the edge ring of the electronic device manufacturing apparatus according to Embodiment 2 of the present invention.
FIG. **8A** is a view illustrating a planar configuration of an edge ring including a shelf of an electronic device manufacturing apparatus according to Embodiment 3 of the present invention and FIG. **8B** is a view illustrating a cross-sectional configuration of the shelf viewed at any part of the edge ring shown in FIG. **8A.**
FIG. **9** is a view illustrating a semiconductor substrate placed on the shelf of the edge ring of the electronic device manufacturing apparatus according to Embodiment 3 of the present invention.
FIG. **10A** is a view illustrating a planar configuration of an edge ring including a shelf of an electronic device manufacturing apparatus according to Embodiment 4 of the present invention and FIG. **10B** is a view illustrating a cross-sectional configuration of the shelf viewed at any part of the edge ring shown in FIG. **10A.**
FIG. **11** is a view illustrating a semiconductor substrate placed on the shelf of the edge ring of the electronic device manufacturing apparatus according to Embodiment 4 of the present invention.
FIG. **12** is a view illustrating a schematic configuration of a conventional RTP apparatus.
FIG. **13A** is a view illustrating a planar configuration of an edge ring including a shelf of the conventional RTP apparatus and FIG. **13B** is a view illustrating a cross-sectional configuration of the shelf viewed at any part of the edge ring shown in FIG. **13A.**
FIG. **14** is a graph of the measurement results of sheet resistance at the surface of a semiconductor substrate which has been implanted with p- or n-type impurities and then subjected to spike RTA using the conventional RTP apparatus.

### DETAILED DESCRIPTION OF THE INVENTION

### Embodiment 1

Hereinafter, with reference to the drawings, an explanation is given of an electronic device manufacturing apparatus and a manufacturing method according to Embodiment 1 of the present invention. In this embodiment, an RTP apparatus is taken as an example.

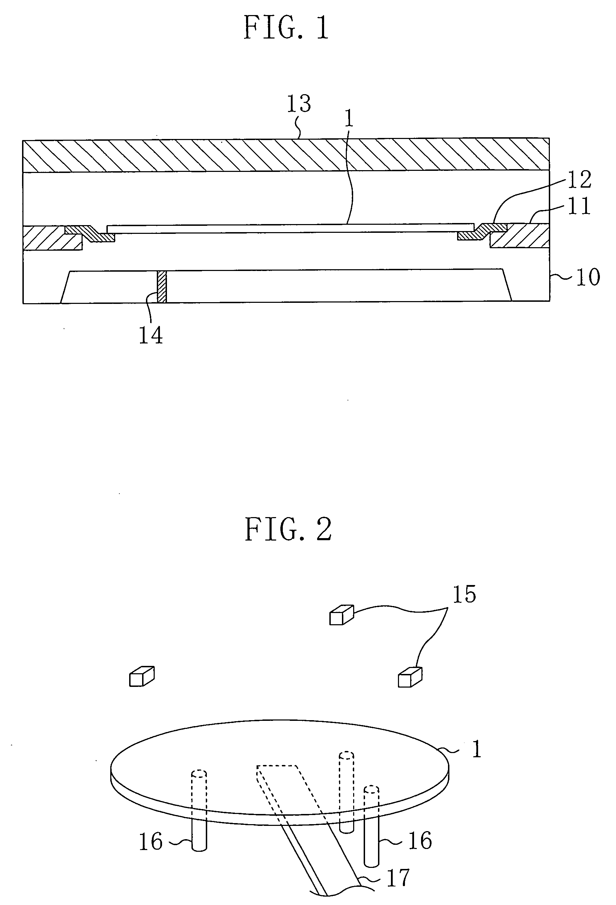

FIG. **1** is a sectional view illustrating a schematic configuration of an electronic device manufacturing apparatus of Embodiment 1. As shown in FIG. **1,** an edge ring **11** for supporting a semiconductor substrate **1** is provided on the sidewall of a chamber **10.** The edge ring **11** includes a shelf **12** for supporting the semiconductor substrate **1.** A heater **13** is provided at the upper part of the chamber **10** so that the semiconductor substrate **1** is heated from above. The heater **13** is divided into two or more regions so that the heating intensity of the heater **13** can be adjusted region by region. Further, a pyrometer **14** is provided at the bottom of the chamber **10** to measure the temperature of the semiconductor substrate **1** (to be exact, the temperature of the rear surface of the semiconductor substrate). Thus, in the apparatus shown in FIG. **1,** thermal processing of the semiconductor substrate **1** is carried out by adjusting the intensity of the heater **13** region by region in accordance with the substrate temperature measured by the pyrometer **14.** Though not shown, the edge ring **11** is provided with a rotating mechanism, and therefore it rotates together with the semiconductor substrate **1** during substrate processing.

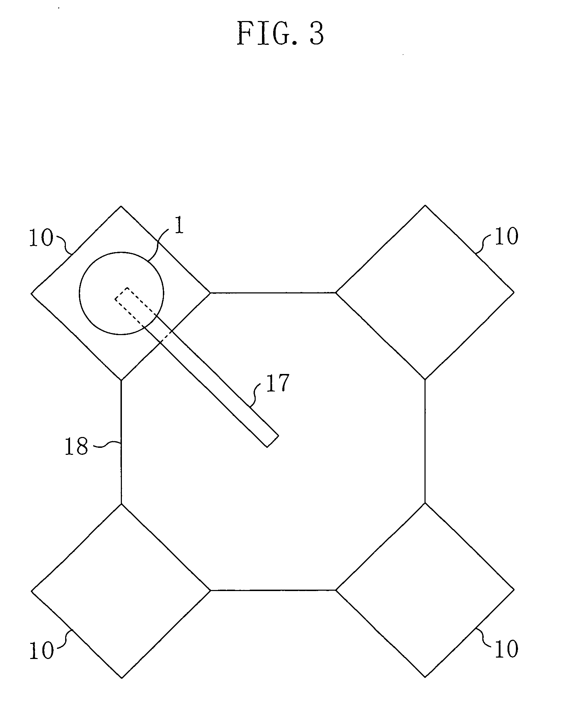

FIG. **2** shows a feature of the present embodiment in the chamber **10.** As shown in FIG. **2,** the chamber **10** includes one or more sensors **15** for obtaining the position of the semiconductor substrate **1** placed on the edge ring **11.** It goes without saying that where to arrange the sensors **15** is not particularly limited. The chamber **10** further includes three support pins **16,** for example, for supporting a wafer as the semiconductor substrate **1** placed on the edge ring **11.** The position of the semiconductor substrate **1** placed on the edge ring **11** is corrected by a substrate position correcting mechanism, i.e., the support pins **16** or a transfer arm **17** (a robot arm for transferring the wafer). As shown in FIG. **3,** the transfer arm **17** is provided for a transfer chamber **18** including two or more chambers **10** shown in FIG. **1.**

Hereinafter, an explanation is given of a method for correcting the substrate position using the substrate position correcting mechanism described above. When the semiconductor substrate **1** is transferred into the chamber **10** and placed on the edge ring **11,** the sensors **15** obtain the position of the semiconductor substrate **1,** to be exact, the interval between the center of the semiconductor substrate 1 and the center of the shelf **12** (i.e., the center of the edge ring **11:** the same is applied below). If the obtained interval is more than 0.3 mm, the position of the semiconductor substrate **1** is corrected using the support pins **16** or the transfer arm **17** to reduce the interval to 0.3 mm or less. Preferably, the interval is reduced to 0.1 mm or less by the correction.

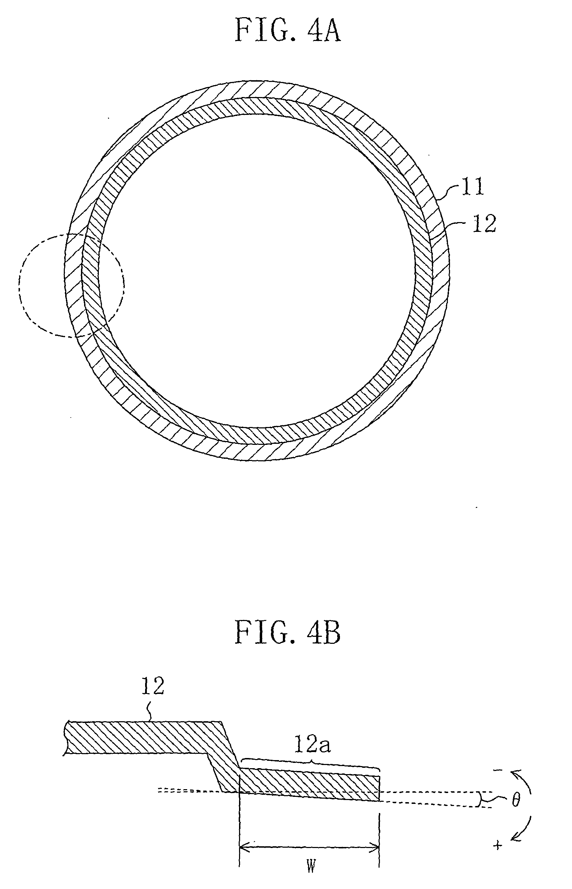

FIG. **4A** shows a planar configuration of the edge ring **11** including the shelf **12** according to the present embodiment, while FIG. **4B** shows a cross-sectional configuration of the shelf **12** viewed at any part of the edge ring **11** shown in FIG. **4A** (e.g., a region circled with an alternate long and short dash line in FIG. **4A).** As shown in FIG. **4B,** the shelf **12** includes a substrate support plane **12a** which forms an angle (θ) of 2° with a horizontal plane and has a length **W** of 3 mm (horizontal length along the direction of the wafer diameter).

In the present invention, as shown in FIG. **4B,** the angle formed by the horizontal plane and the substrate support plane **12a** whose distal end is positioned lower than the horizontal plane is regarded as a positive angle, while the angle formed by the horizontal plane and the substrate support plane **12a** whose distal end is positioned upper than the horizontal plane is regarded as a negative angle.

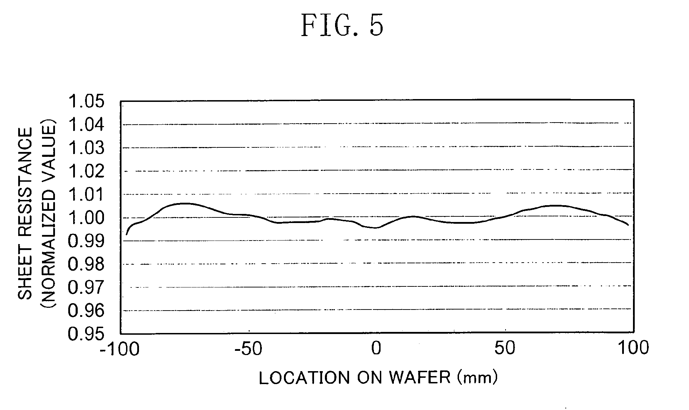

FIG. **5** is a graph of the measurement results of sheet resistance at the surface of the semiconductor substrate **1** which has been implanted with p- or n-type impurities and then subjected to RTP (spike RTA) using the manufacturing apparatus of the present embodiment. In FIG. **5,** the lateral axis indicates locations on the wafer as the semiconductor substrate **1** (represented by the distance from the wafer center (0) along the direction of the wafer diameter) and the longitudinal axis indicates normalized sheet resistance.

As shown in FIG. **5,** the measured sheet resistance has improved in uniformity as compared with the sheet resistance measured at the wafer periphery after spike RTA performed with the conventional manufacturing apparatus (see FIG. **14).** At almost every part of the surface of the wafer (semiconductor substrate 1), the sheet resistance is symmetric to that at the wafer center. To be more specific, variations in sheet resistance are restricted within 3°C on temperature conversion.

That is, according to Embodiment 1, the sensors **15** obtain the position of the semiconductor substrate **1** placed on the shelf **12** of the edge ring **11,** and then the position correcting mechanism (e.g., the support pins **16** or the transfer arm **17)** corrects the position of the semiconductor substrate **1** based on the obtained results. Since the semiconductor substrate **1** is positioned properly such that the center thereof is aligned with the center of the shelf **12,** every part of the periphery of semiconductor substrate **1** contacts the shelf **12** with the same contact area. That is, the state of contact of the semiconductor substrate **1** with the shelf **12** becomes the same in every part thereof. Therefore, heat balance at the periphery of the semiconductor substrate **1** contacting the shelf **12** is brought into better balance with that at the other part of the semiconductor substrate **1** not contacting the shelf **12.** As a result, temperature uniformity improves across the substrate surface during thermal processing, specifically RTP.

Further, according to Embodiment 1, the length **W** of the substrate support plane **12a** of the shelf **12** is at most about 3 mm, and therefore the area of contact between the periphery of the semiconductor substrate **1** and the shelf **12** is reduced. As a result, heat balance at the periphery of the semiconductor substrate **1** contacting the shelf **12** becomes less different from that at the other part of the semiconductor substrate **1** not contacting the shelf **12.** Thus, the temperature uniformity further improves across the substrate surface during RTP.

In Embodiment 1, the length **W** of the substrate support plane **12a** is set to 3 mm. However, the same effect is obtained as in the present embodiment even if the length **W** is 3 mm or less.

In Embodiment **1,** the angle θ formed by the substrate support plane **12a** of the shelf **12** and the horizontal plane is set to 2°. However, the same effect is obtained as in the present embodiment as long as the angle θ is in the range of -5° or more to 22° or less.

In Embodiment 1, the substrate position correcting mechanism may be provided inside the process chamber. Or alternatively, a robot arm of a transfer system provided outside the process chamber may be used as the substrate position correcting mechanism. In either case, the same effect is obtained as in the present embodiment.

### Embodiment 2

Hereinafter, with reference to the drawings, an explanation is given of an electronic device manufacturing apparatus according to Embodiment 2 of the present invention. In this embodiment, an RTP apparatus is taken as an example. A feature of the present embodiment lies in an edge ring **11** (especially a shelf **12** thereof) in an electronic device manufacturing apparatus as shown in FIG. **1** (an RTP apparatus, to be exact). Except this feature, the manufacturing apparatus of Embodiment 2 is configured in the same manner as that of Embodiment 1.

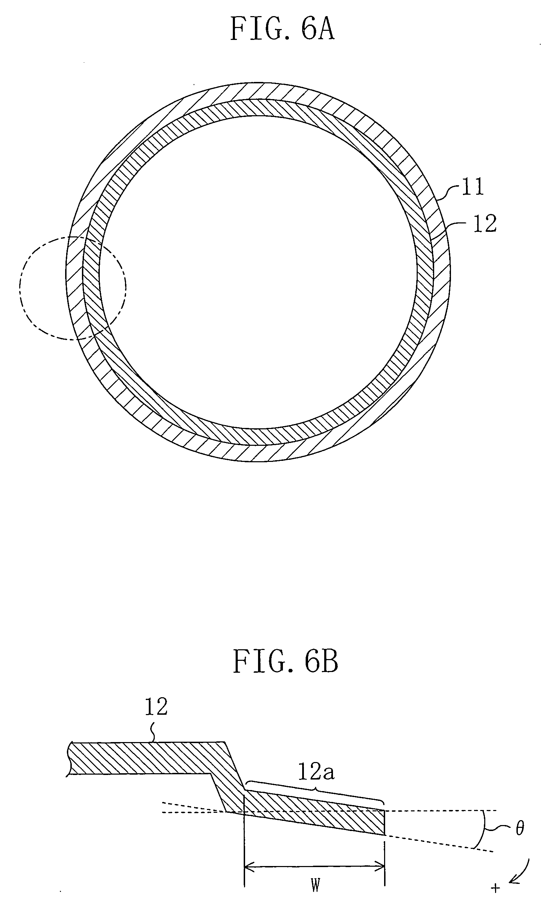

FIG. **6A** shows a planar configuration of the edge ring **11** including the shelf **12** according to the present embodiment, while FIG. **6B** shows a cross-sectional configuration of the shelf **12** viewed at any part of the edge ring **11** shown in FIG. **6A** (e.g., a region circled with an alternate long and short dash line in FIG. **6A).** As shown in FIG. **6B,** the shelf **12** includes a substrate support plane **12a** which forms an angle (θ) of 22° with a horizontal plane and has a length **W** of 4 mm (horizontal length along the direction of the wafer diameter).

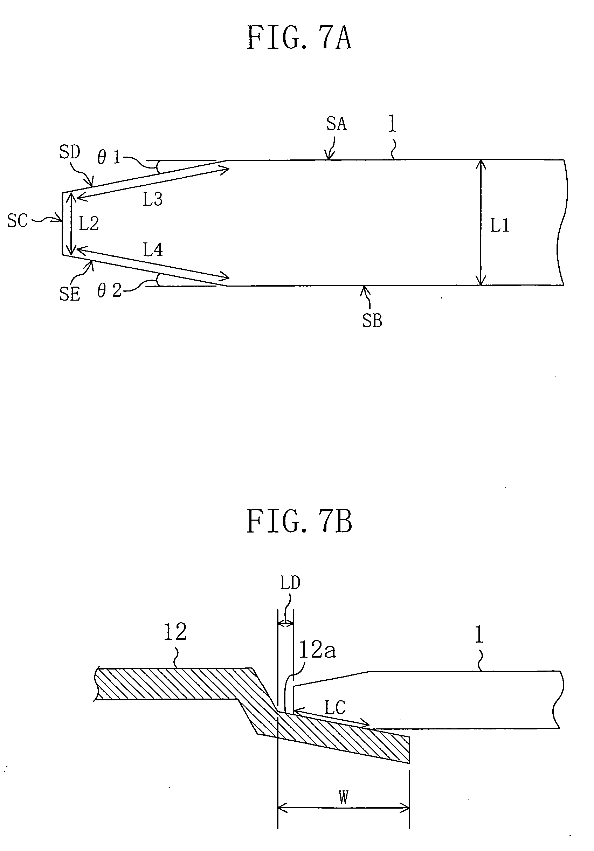

FIG. **7A** shows a cross-sectional configuration of the periphery of the semiconductor substrate **1** to be placed on the shelf **12** of the edge ring **11** of the present embodiment, while FIG. **7B** shows the semiconductor substrate **1** placed on the shelf **12** of the edge ring **11** of the present embodiment.

As shown in FIG. **7A,** the front surface (upper surface) **SA** and the rear surface (lower surface) **SB** of the semiconductor substrate 1 are given with an upper beveled face **SD** and a lower beveled face **SE** which are in contact with an end face (peripheral face) SC of the semiconductor substrate **1,** respectively. An angle θ1 formed by the upper surface **SA** and the upper beveled face **SD** and an angle θ2 formed by the lower surface **SB** and the lower beveled face **SE** are about 22° to 23°, respectively. Further, as shown in FIG. **7A,** the semiconductor substrate **1** has a thickness **L1** (distance from the upper surface **SA** to the lower surface **SB)** of about 770 µm, for example. The end face **SC** has a length **L2** of about 385 µm and the upper beveled face **SD** and the lower beveled face **SE** have lengths **L3** and **L4** of about 500 µm, respectively. Further, as shown in FIG. **7B,** a ring-shaped part, which serves as the substrate support plane **12a** of the shelf **12** of the edge ring **11,** has a diameter (outer diameter: hereinafter referred to as an inner diameter of the shelf **12)** which is 1 mm larger than the diameter of a wafer as the semiconductor substrate **1.** That is, where the center of the edge ring **11** is aligned with the center of the semiconductor substrate **1,** a distance **LD** shown in FIG. **7B** is about 500 µm.

With use of the thus-configured edge ring **11,** the substrate support plane **12a** of the shelf **12** contacts the lower beveled face **SE** of the semiconductor substrate **1** as shown in FIG. **7B.** At this time, part of the periphery of the semiconductor substrate **1** contacting the shelf **12** has a length **LC** of about 500 µm, which is equal to the length **L4** of the lower beveled face **SE** (see FIG. **7A).**

According to Embodiment 2, the shelf **12** supporting the semiconductor substrate **1** includes the substrate support plane **12a** which forms an angle of 22° or more to less than 23° with the horizontal plane. Therefore, even if the center of the semiconductor substrate **1** is misaligned with the center of the shelf **12** (the center of the edge ring **11)** when the semiconductor substrate **1** is placed on the shelf **12,** the semiconductor substrate **1** slides along the substrate support plane **12a** of the shelf **12** under its own weight, whereby the center of the semiconductor substrate **1** is aligned with the center of the shelf **12.** At this time, the interval between the center point of the shelf **12** and the center point of the semiconductor substrate **1** is reduced to 0.3 mm or less, or possibly 0.1 mm or less. As a result, every part of the periphery of semiconductor substrate **1** contacts the shelf **12** with the same contact area. That is, the state of contact of the semiconductor substrate **1** with the shelf **12** becomes the same in every part thereof. Therefore, heat balance at the periphery of the semiconductor substrate **1** contacting the shelf **12** is brought into better balance with that at the other part of the semiconductor substrate **1** not contacting the shelf **12.** As a result, temperature uniformity improves across the substrate surface during thermal processing, specifically RTP. Where the center of the semiconductor substrate **1** is aligned with the center of the shelf **12,** the substrate support plane **12a** is brought into contact with the lower beveled face **SE** of the semiconductor substrate **1** whose length is as small as about 1 mm (length in the direction of the wafer diameter). This reduces the area of contact between every part of the periphery of the semiconductor substrate **1** and the shelf **12.** As a result, heat balance at the periphery of the semiconductor substrate **1** contacting the shelf **12** becomes less different from that at the other part of the semiconductor substrate **1** not contacting the shelf **12.** Thus, temperature uniformity further improves across the substrate surface during RTP.

With use of the edge ring **11** of the present embodiment, the shelf **12** of the edge ring **11** contacts the semiconductor substrate 1 by 1 mm or less and every part of the periphery of semiconductor substrate 1 contacts the shelf **12** with the same contact area. Thus, the above-described significant effect is obtained.

In Embodiment 2, the angle 0 formed by the substrate support plate **12a** of the shelf 12 and the horizontal plane is 22°. However, the same effect is obtained as in the present embodiment even if the angle θ is in the range of 22° or more to less than 23°.

In Embodiment 2, the inner diameter of the shelf **12** of the edge ring **11** is made **1** mm larger than the diameter of the semiconductor substrate **1.** However, the same effect is obtained as in the present embodiment as long as the inner diameter of the shelf **12** is larger than the diameter of the semiconductor substrate **1.**

In Embodiment 2, the length **W** of the substrate support plate **12a** is 4 mm. However, even if the length **W** is 2 mm or more, the same effect is obtained as in the present embodiment, i.e., the semiconductor substrate **1** slides along the substrate support plane **12a** under its own weight such that the center of the semiconductor substrate **1** is aligned with the center of the shelf **12.**

### Embodiment 3

Hereinafter, with reference to the drawings, an explanation is given of an electronic device manufacturing apparatus according to Embodiment 3 of the present invention. In this embodiment, an RTP apparatus is taken as an example. A feature of the present embodiment lies in an edge ring **11** (especially a shelf **12** thereof) of an electronic device manufacturing apparatus as shown in FIG. **1** (an RTP apparatus, to be exact). Except this feature, the manufacturing apparatus of Embodiment 3 is configured in the same manner as that of Embodiment 1.

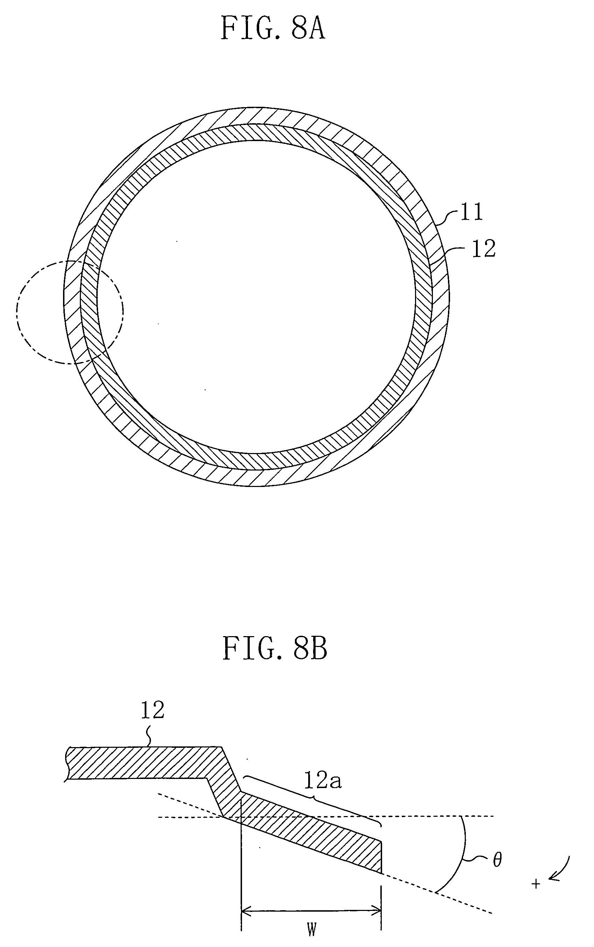

FIG. **8A** shows a planar configuration of the edge ring **11** including the shelf **12** according to the present embodiment, while FIG. **8B** shows a cross-sectional configuration of the shelf **12** viewed at any part of the edge ring **11** shown in FIG. **8A** (e.g., a region circled with an alternate long and short dash line in FIG. **8A).** As shown in FIG. **8B,** the shelf **12** includes a substrate support plane **12a** which forms an angle (θ) of 45° with a horizontal plane and has a length **W** of 4 mm (horizontal length along the direction of the wafer diameter).

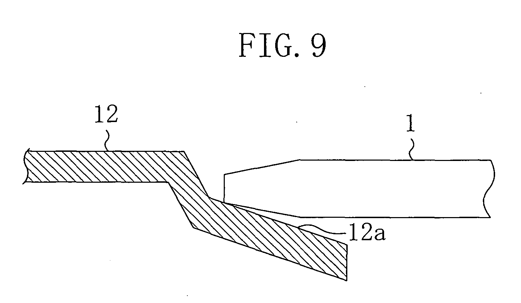

FIG. **9** shows a semiconductor substrate **1** placed on the shelf **12** of the edge ring **11.** As shown in FIG. **9,** a ring-shaped part, which serves as the substrate support plane **12a** of the shelf **12** of the edge ring **11,** has a larger diameter (outer diameter: hereinafter referred to as the inner diameter of the shelf **12)** than a wafer as the semiconductor substrate **1.** More specifically, the inner diameter of the shelf **12** is 1 mm larger than the diameter of the semiconductor substrate **1.**

With use of the thus-configured edge ring **11,** as shown in FIG. **9,** the substrate support plane **12a** of the shelf **12** contacts the semiconductor substrate **1** at an edge of the semiconductor substrate **1** at which the lower beveled face **SE** meets the end face **SC** (see FIG. **7A).**

According to Embodiment 3, the shelf **12** supporting the semiconductor substrate **1** has the substrate support plane **12a** which forms an angle of 45° with the horizontal plane. Therefore, even if the center of the semiconductor substrate **1** is misaligned with the center of the shelf **12** (the center of the edge ring **11)** when the semiconductor substrate **1** is placed on the shelf **12,** the semiconductor substrate **1** slides along the substrate support plane **12a** of the shelf **12** under its own weight, whereby the center of the semiconductor substrate **1** is aligned with the center of the shelf **12.** At this time, the interval between the center point of the shelf **12** and the center point of the semiconductor substrate **1** is reduced to 0.3 mm or less, or possibly 0.1 mm or less. As a result, every part of the periphery of semiconductor substrate **1** contacts the shelf **12** with the same contact area. That is, the state of contact of the semiconductor substrate **1** with the shelf **12** becomes the same in every part thereof. Therefore, heat balance at the periphery of the semiconductor substrate **1** contacting the shelf **12** is brought into better balance with that at the other part of the semiconductor substrate **1** not contacting the shelf **12.** As a result, temperature uniformity improves across the substrate surface during thermal processing, specifically RTP. Where the center of the semiconductor substrate **1** is aligned with the center of the shelf **12,** the substrate support plane **12a** is brought into contact with the edge of the semiconductor substrate **1** at which the lower beveled face **SE** meets the end face **SC.** This reduces the area of contact between every part of the periphery of the semiconductor substrate **1** and the shelf **12.** As a result, heat balance at the periphery of the semiconductor substrate **1** contacting the shelf **12** becomes less different from that at the other part of the semiconductor substrate **1** not contacting the shelf **12.** Thus, temperature uniformity further improves across the substrate surface during RTP.

With use of the edge ring **11** of the present embodiment, the shelf **12** of the edge ring **11** and the semiconductor substrate **1** contact each other such that the contacting part is substantially in the form of a line and the state of contact of the semiconductor substrate **1** with the shelf **12** becomes the same in every part thereof. Thus, the above-described significant effect is obtained.

In Embodiment 3, the angle θ formed by the substrate support plane **12a** of the shelf **12** and the horizontal plane is 45°. However, the same effect is obtained as in the present embodiment even if the angle θ is in the range of 23° or more to less than 90°.

In Embodiment 3, the inner diameter of the shelf **12** of the edge ring **11** is 1 mm larger than the diameter of the semiconductor substrate **1.** However, the same effect is obtained as in the present embodiment as long as the inner diameter of the shelf **12** is larger than the diameter of the semiconductor substrate **1.**

In Embodiment 3, the length W of the substrate support plane **12a** is 4 mm. However, even if the length **W** is 2 mm or more, the same effect is obtained as in the present embodiment, i.e., the semiconductor substrate **1** slides along the substrate support plane **12a** under its own weight such that the center of the semiconductor substrate **1** is aligned with the center of the shelf **12.**

### Embodiment 4

Hereinafter, with reference to the drawings, an explanation is given of an electronic device manufacturing apparatus according to Embodiment 4 of the present invention. In this embodiment, an RTP apparatus is taken as an example. A feature of the present embodiment lies in an edge ring **11** (especially a shelf **12** thereof) of an electronic device manufacturing apparatus as shown in FIG. **1** (an RTP apparatus, to be exact). Except this feature, the manufacturing apparatus of Embodiment 4 is configured in the same manner as that of Embodiment 1.

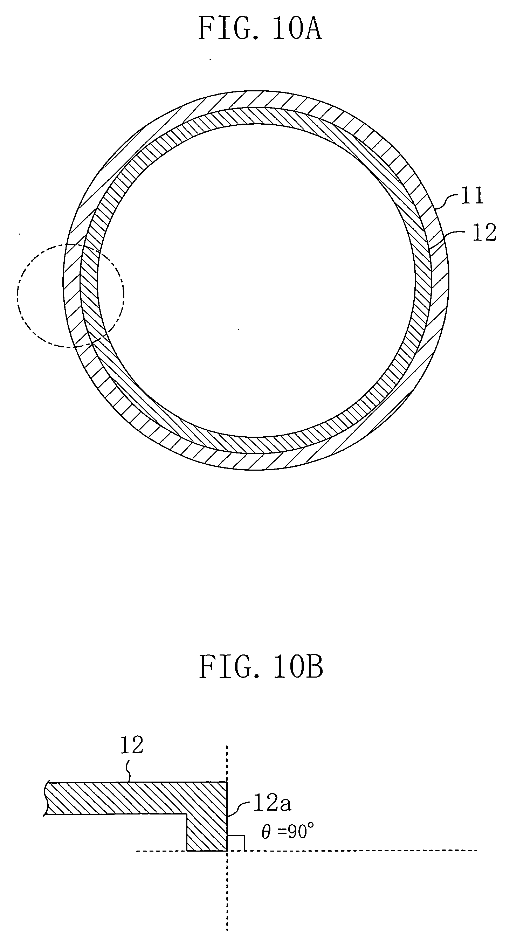

FIG. **10A** shows a planar configuration of the edge ring **11** including the shelf **12** according to the present embodiment, while FIG. **10B** shows a cross-sectional configuration of the shelf **12** viewed at any part of the edge ring **11** shown in FIG. **10A** (e.g., a region circled with an alternate long and short dash line in FIG. **10A).** As shown in FIG. **10B,** the shelf **12** includes a substrate support plane **12a** which forms an angle (θ) of 90° with a horizontal plane.

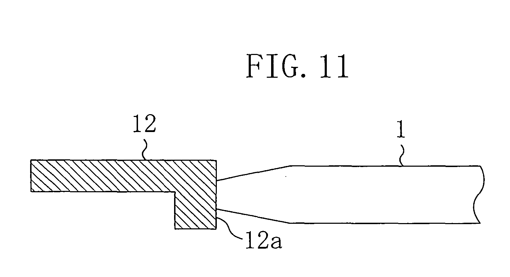

FIG. **11** shows the semiconductor substrate **1** supported by the shelf **12** of the edge ring **11** of the present embodiment. As shown in FIG. **11,** the inner diameter of the shelf **12** of the edge ring **11** is the same as the diameter of a wafer as the semiconductor substrate **1.**

With use of the thus-configured edge ring **11,** as shown in FIG. **11,** the substrate support plane **12a** of the shelf **12** contacts the end face **SC** (see FIG. **7A)** of the semiconductor substrate **11.** At this time, part of the periphery of the semiconductor substrate **1** contacting the shelf 12 has a length of about 400 µm, which is the same as the length **L3** of the end face **SC** (see FIG. **7A).**

In Embodiment **4,** the shelf **12** supporting the semiconductor substrate **1** includes the substrate support plane **12a** which forms an angle of 90° with the horizontal plane. That is, the semiconductor substrate **1** is supported in such a state that the end face **SC** thereof contacts the substrate support plane **12a** of the shelf **12.** Thus, the center of the semiconductor substrate **1** is aligned with the center of the shelf **12.** At this time, the interval between the center point of the semiconductor substrate **1** and the center point of the shelf **12** is reduced to 0.3 mm or less, or possibly 0.1 mm or less. As a result, every part of the periphery of semiconductor substrate **1** contacts the shelf **12** with the same contact area. That is, the state of contact of the semiconductor substrate **1** with the shelf **12** becomes the same in every part thereof. Therefore, heat balance at the periphery of the semiconductor substrate **1** contacting the shelf **12** is brought into better balance with that at the other part of the semiconductor substrate **1** not contacting the shelf **12.** As a result, temperature uniformity improves across the substrate surface during thermal processing, specifically RTP. Where the center of the semiconductor substrate **1** is aligned with the center of the shelf **12,** the substrate support plane **12a** is brought into contact with the end face **SC** of the semiconductor substrate **1** which is as small as about 1 mm in length (length along the direction vertical to the wafer surface). This reduces the area of contact between every part of the periphery of the semiconductor substrate **1** and the shelf **12.** As a result, the heat balance at the periphery of the semiconductor substrate **1** contacting the shelf **12** becomes less different from that at the other part of the semiconductor substrate not contacting the shelf **12.** Thus, temperature uniformity further improves across the substrate surface during **RTP.**

With use of the edge ring **11** of the present embodiment, part of the semiconductor substrate **1** contacting the shelf **12** of the edge ring **11** substantially has a length of 1 mm or less and every part of the periphery of semiconductor substrate **1** contacts the shelf **12** with the same contact area. Therefore, the above-described significant effect is obtained.

## Claims

1. An electronic device manufacturing apparatus comprising:
a support which includes a shelf for supporting a substrate;
a sensor which obtains the position of the substrate; and
a position correcting mechanism which corrects the position of the substrate.

2. An electronic device manufacturing apparatus according to claim 1, wherein
the shelf includes a substrate support plane which forms an angle of-5° or more to 22° or less with a horizontal plane.

3. An electronic device manufacturing apparatus according to claim 1, wherein
the substrate support plane of the shelf has a horizontal length of 3 mm or less.

4. An electronic device manufacturing apparatus according to claim 1, wherein
the position correcting mechanism sets the interval between the center point of the shelf and the center point of the substrate to 0.3 mm or less.

5. An electronic device manufacturing apparatus according to claim 1, wherein
the position correcting mechanism is provided inside a chamber in which the shelf is arranged.

6. An electronic device manufacturing apparatus according to claim 1, wherein
the position correcting mechanism is provided outside a chamber in which the shelf is arranged.

7. A method for manufacturing an electronic device using an electronic device manufacturing apparatus of claim 1, the method comprising the steps of:
placing the substrate on the shelf;
obtaining the position of the substrate placed on the shelf using the sensor; and
correcting the position of the substrate using the position correcting mechanism based on the position of the substrate obtained by the sensor.

8. An electronic device manufacturing apparatus comprising
a support which includes a shelf for supporting a substrate, wherein
the shelf includes a substrate support plane which forms an angle of 22° or more to less than 23° with a horizontal plane.

9. An electronic device manufacturing apparatus according to claim 8, wherein
the substrate support plane contacts a beveled face of the substrate.

10. An electronic device manufacturing apparatus according to claim 8, wherein
the interval between the center point of the shelf and the center point of the substrate placed on the shelf is 0.3 mm or less.

11. An electronic device manufacturing apparatus according to claim 8, wherein
the inner diameter of the shelf is larger than the diameter of a wafer as the substrate.

12. An electronic device manufacturing apparatus according to claim 8, wherein
the substrate support plane has a horizontal length of 2 mm or more.

13. An electronic device manufacturing apparatus comprising
a support which includes a shelf for supporting a substrate, wherein
the shelf includes a substrate support plane which forms an angle of 23° or more to less than 90° with a horizontal plane.

14. An electronic device manufacturing apparatus according to claim 13, wherein
the substrate support plane contacts an edge of the substrate at which a beveled face of the substrate meets an end face of the substrate.

15. An electronic device manufacturing apparatus according to claim 13, wherein
the interval between the center point of the shelf and the center point of the substrate placed on the shelf is 0.3 mm or less.

16. An electronic device manufacturing apparatus according to claim 13, wherein
the inner diameter of the shelf is larger than the diameter of the substrate.

17. An electronic device manufacturing apparatus according to claim 13, wherein
the substrate support plane has a horizontal length of 2 mm or more.

18. An electronic device manufacturing apparatus comprising:
a support which includes a shelf for supporting a substrate; wherein
the shelf includes a substrate support plane which forms an angle of 90° with a horizontal plane.

19. An electronic device manufacturing apparatus according to claim 18, wherein
the substrate support plane contacts an end face of the substrate.

20. An electronic device manufacturing apparatus according to claim 18, wherein
the interval between the center point of the shelf and the center point of the substrate placed on the shelf is 0.3 mm or less.

21. An electronic device manufacturing apparatus according to claim 18, wherein
the inner diameter of the shelf is the same as the diameter of the substrate.

22. An electronic device manufacturing apparatus according to claim 1 further comprising:
a heater which heats the substrate and is divided into two or more regions; and
a temperature measure which measures the temperature of the substrate, wherein
the substrate is subjected to thermal processing while the intensity of the heater is adjusted region by region in accordance with the temperature measured by the temperature measure.

23. An electronic device manufacturing apparatus according to claim 8 further comprising:
a heater which heats the substrate and is divided into two or more regions; and
a temperature measure which measures the temperature of the substrate, wherein
the substrate is subjected to thermal processing while the intensity of the heater is adjusted region by region in accordance with the temperature measured by the temperature measure.

24. An electronic device manufacturing apparatus according to claim 13 further comprising:
a heater which heats the substrate and is divided into two or more regions; and
a temperature measure which measures the temperature of the substrate, wherein
the substrate is subjected to thermal processing while the intensity of the heater is adjusted region by region in accordance with the temperature measured by the temperature measure.

25. An electronic device manufacturing apparatus according to claim 18 further comprising:
a heater which heats the substrate and is divided into two or more regions; and
a temperature measure which measures the temperature of the substrate, wherein
the substrate is subjected to thermal processing while the intensity of the heater is adjusted region by region in accordance with the temperature measured by the temperature measure.
